# EUROPÄISCHE PATENTSCHRIFT

(11) **EP 2 138 023 B1**
(45) Veröffentlichungstag und Bekanntmachung des Hinweises auf die Patenterteilung: **16.02.2011**
(21) Anmeldenummer: 08748845.8
(22) Anmeldetag: 20.03.2008
(51) Int. Cl.: H05K 7/20, H02B 1/56

(54) **SCHALTSCHRANK ODER RACK MIT EINER FLUID-VERTEILEREINRICHTUNG**
SWITCHGEAR CABINET OR RACK WITH A FLUID DISTRIBUTION DEVICE
ARMOIRE DE COMMANDE OU ARMOIRE À MODULES CONNECTABLES PRÉSENTANT UN BLOC RÉPARTITEUR DE FLUIDE

(30) Priorität: 21.03.2007 DE 102007013520
(43) Veröffentlichungstag der Anmeldung: 30.12.2009
(73) Patentinhaber: Rittal Gmbh&Co. Kg, 35745 Herborn (DE)
(72) Erfinder: HÖHNE, Thorsten, 35683 Dillenburg (DE)
(74) Vertreter: Fleck, Hermann-Josef
(86) Internationale Anmeldenummer: PCT/EP2008/002281
(87) Internationale Veröffentlichungsnummer: WO 2008/113603

(56) Entgegenhaltungen:
- EP-A- 0 361 196
- EP-A- 1 448 040
- WO-A-2004/082088
- DE-U1-202004 020 315
- US-A1- 2005 207 116

## Beschreibung

Die Erfindung bezieht sich auf einen Schaltschrank oder ein Rack mit einem unter einem Nutzraum angeordneten Sockel und einer eine Kühlmittel-Leitung aufweisenden Verteilereinrichtung für ein eine Kühleinrichtung durchströmendes Kühlmedium.

Ein Schaltschrank mit einer derartigen Verteilereinrichtung zum Zuführen eines flüssigen Kühlmediums zu einer Kühleinrichtung, z. B. in Form einer Kühlplatte, ist in dem Katalog "RITTAL-Neuheiten 2005" vom April 2005 auf Seite 59 angegeben, wo auch auf einen Kühlmittelzugang und -abgang und den Anschluss an eine Rückkühlanlage für einen geschlossenen Kühlkreislauf hingewiesen ist. Die Verteilung des Kühlmediums, nämlich Wassers, mit entsprechender Leitungsführung und Verbindungselementen erfolgt dabei projektbezogen mit entsprechendem Installationsaufwand.

Einen weiteren Schaltschrank mit ähnlicher Verteilereinrichtung für eine Kühleinrichtung zeigt auch die Broschüre "RITTAL DCP - Direct Cooling Package" vom April 2005.

Der Erfindung liegt die Aufgabe zugrunde, einen Schaltschrank oder ein Rack der eingangs genannten Art bereit zu stellen, mit dem eine vereinfachte Installation der Verteilereinrichtung für ein Kühlmedium erreicht wird.

Diese Aufgabe wird mit den Merkmalen des Anspruches 1 gelöst. Hierbei ist vorgesehen, dass die Verteilereinrichtung als Grundverteilereinheit ausgebildet ist, die im Bereich des Sockels installiert ist und sich mit mindestens einem Leitungsrohr zwischen zwei parallel beabstandeten vertikalen Begrenzungsebenen des Sockels erstreckt, und dass das Leitungsrohr mit mindestens einem Abzweigstück zum Anschluss der Kühleinrichtung versehen ist.

Die Grundverteilereinheit ergibt einfache Anschlussmöglichkeiten für die das Kühlmittel zu der jeweiligen Kühleinrichtung führenden Leitungen bei nicht störendem, platzsparendem Einbau.

Eine für den Einbau und die Zugänglichkeit vorteilhafte Ausbildung besteht darin, dass sich das mindestens eine Leitungsrohr zwischen zwei Seitenblenden des Sockels erstreckt und über mindestens eine Seitenblende und/oder mindestens ein Eckstück mit dem Sockel verbunden ist.

Für eine einfache, stabile Montage ist vorteilhaft vorgesehen, dass die Grundverteilereinheit zum Verbinden des mindestens einen Leitungsrohrs mit dem Sockel mindestens eine Befestigungseinheit aufweist.

Für eine einfache Installation und sichere Funktion sind die Maßnahmen von Vorteil, dass zumindest ein Endabschnitt und/oder das Abzweigstück des jeweiligen Leitungsrohres mit einem freigebbaren Schließelement zum fluiddichten Verschließen des Leitungsrohres versehen sind.

Weitere vorteilhafte Maßnahmen, die zur einfachen Installation und sicheren Funktion beitragen, bestehen darin, dass die Grundverteilereinheit durch Anbringung einer mit einem Steckteil versehenen Schnellverschlusskupplung an einem Ende des jeweiligen Leitungsrohres als Anreihverteilereinheit ausgebildet ist. Hierdurch können z. B. weitere Schaltschränke oder Racks, vorzugsweise mit entsprechenden Grundverteilereinheiten einfach seitlich an dem Schaltschrank oder Rack angereiht werden, wobei sich eine einfache Verbindung zum Durchleiten des Kühlfluids ergibt.

Eine nicht störende Unterbringung wird ferner dadurch begünstigt, dass der Sockel auf seiner Oberseite mittels einer Sockelabdeckung abgedeckt ist, die zum Durchführen einer Verbindungsleitung zwischen dem jeweiligen Abzweigstück und der Kühleinrichtung mit mindestens einem dichtenden Durchführelement versehen ist.

Mit den Maßnahmen, dass die Befestigungseinheit zwei gegeneinander verspannbare Klemmenschalen aufweist, die jeweils einstückig mit jeweiligen Halteaufnahmen für alle Rohrleitungen ausgebildet sind, wird eine einfache, stabile Anbringung der z. B. zwei oder auch mehr Leitungsrohre erreicht.

Für einen einfachen Anschluss, beispielsweise bei einer Anreihung eines weiteren Schaltschranks oder Racks, ist vorteilhaft vorgesehen, dass die Seitenblenden mit Durchbrüchen für die Leitungsrohre versehen sind.

Für die Anordnung und Installation ergeben sich auch Vorteile dadurch, dass die Seitenblenden aus einer unteren und einer oberen Teilblende zusammengesetzt sind.

Günstige Montagemöglichkeiten werden dadurch geboten, dass die Seitenblenden zumindest an ihrem oberen Längsrand bezüglich des Sockelraumes rechtwinklig nach innen abgekantet sind und in dem abgekanteten Abschnitt Befestigungslöcher aufweisen.

Die Erfindung wird nachfolgend anhand von Ausführungsbeispielen unter Bezugnahme auf die Zeichnungen näher erläutert. Es zeigen:
- Fig. 1: eine perspektivische Darstellung zum Einbau einer Grundverteilerein- heit im Sockelbereich eines Schaltschranks mit Anschlusskomponenten und Anreihsockel,
- Fig. 2: eine vergrößerte Darstellung der Grundverteilereinheit nach Fig. 1 vor einem Einbau in den Sockel,
- Fig.3: ein Eckstück eines Sockels und ein daran anzubringendes Befesti- gungsstück der Grundverteilereinheit in perspektivischer Ansicht,
- Fig. 4: eine Grundverteilereinheit in Draufsicht,
- Fig. 5: eine als Anreiheinheit ausgestaltete Grundverteilereinheit in Draufsicht,
- Fig. 6: verschiedene Ansichten eines Befestigungsstücks der Grundverteiler- einheit,
- Fig.7: zwei aneinander gekoppelte Grundverteilereinheiten bei Anreihung zweier Schaltschränke in Draufsicht und
- Fig. 8: eine in einen Sockel eingebaute Grundverteilereinheit mit Anschlusslei- tungen in seitlicher Ansicht.

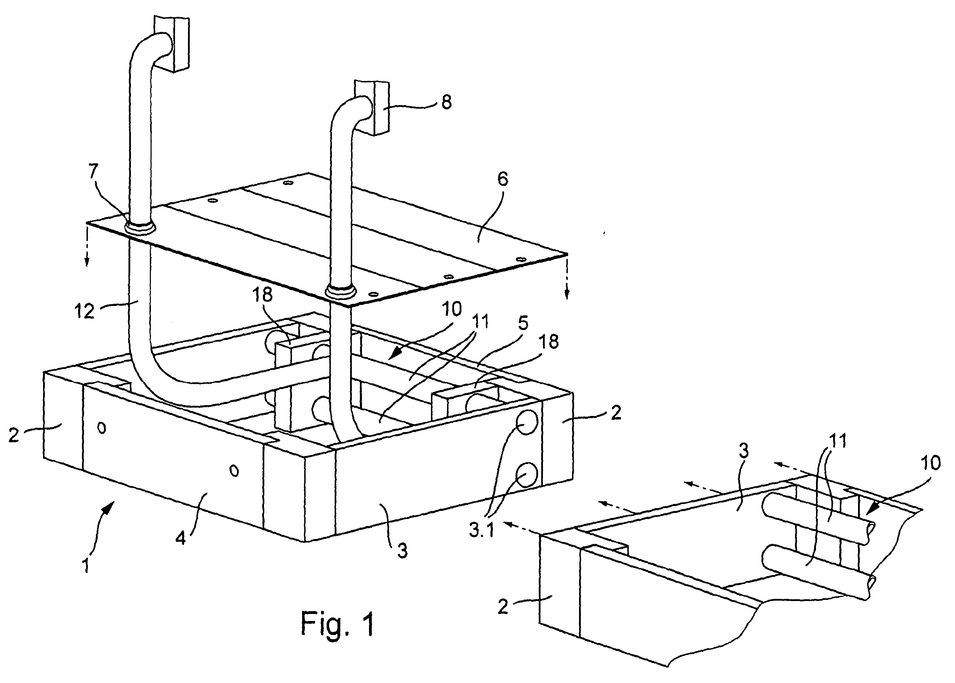

Fig. 1 zeigt einen Sockel 1 eines Schaltschranks, in den eine Grundverteilereinheit 10 für ein fluidförmiges Kühlmedium, wie z. B. Wasser, eingebaut ist. Die Grundverteilereinheit 10 ist über Anschlussleitungen 12, die mittels dichtender Durchführelemente 7 durch eine Sockelabdeckung 6 geführt sind, mit Leitungskanälen 8 verbunden, an die eine Kühleinrichtung, beispielsweise in Form einer Kühlplatte mit geschlängelter Kühlleitung einströmseitig und ausströmseitig anschließbar ist. Auch der Anschluss anderer von einem fluidförmigen Kühlmedium durchströmter Kühleinrichtungen ist möglich.

Der Sockel 1 ist auf seiner Vorder- und Rückseite mit einer Frontblende 4 bzw. Rückblende 5 und seitlich von Seitenblenden 3 umgeben und wird mittels der Sockelabdeckung 6 auf seiner Oberseite abgedeckt, so dass die Sockelblenden 3, 4, 5 zusammen mit der Sockelabdeckung 6 einen quaderförmigen Sockelraum umgrenzen, der von einem oberhalb der Sockelabdeckung 6 befindlichen Nutzraum im Inneren des Schaltschrankes abtrennt ist.

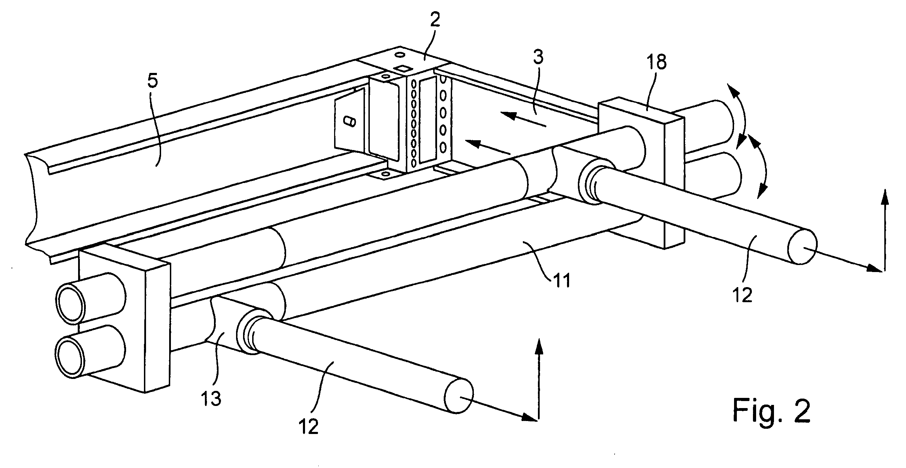

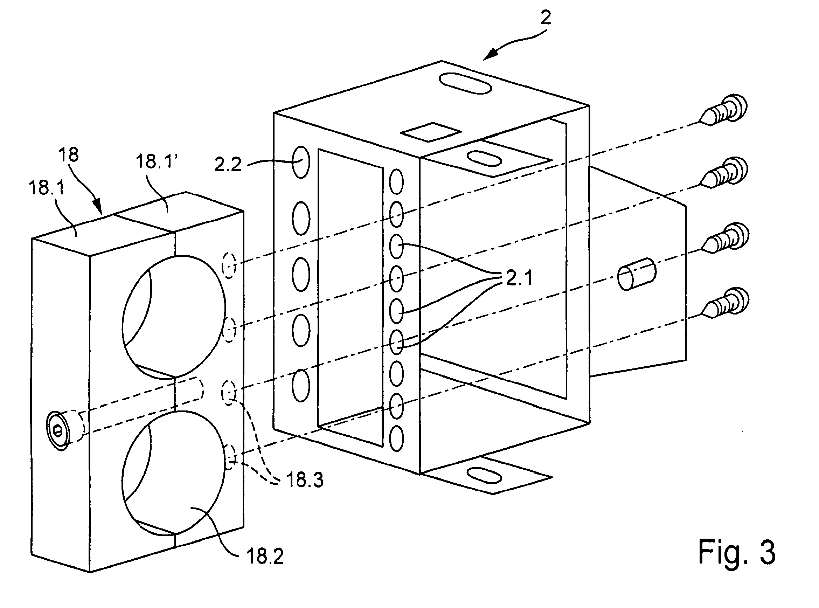

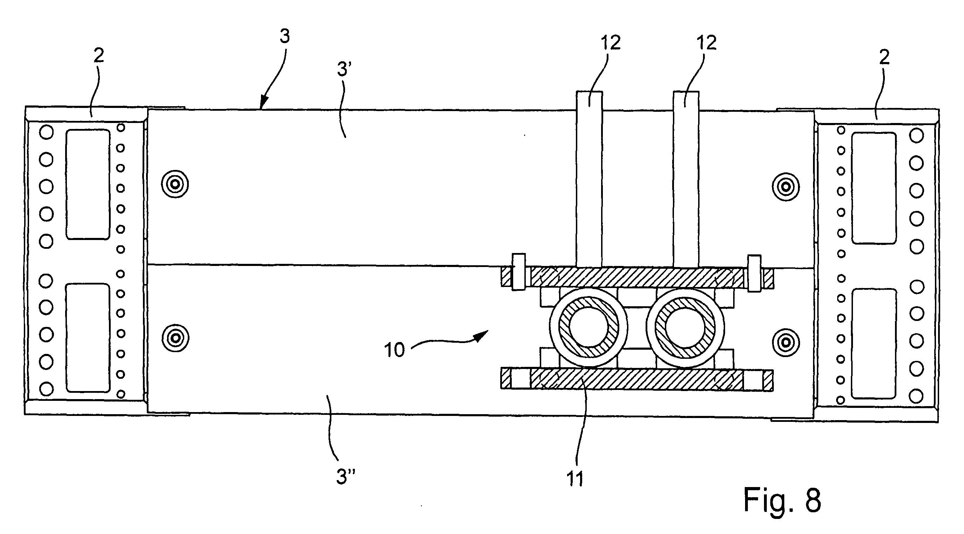

Die Sockelblenden bestehen vorzugsweise aus Blech-Wandelementen, die zumindest an ihrem oberen Längsrand rechtwinklig abgekantet sind, wobei die abgekanteten Randabschnitte zum Inneren des Sockelraumes gerichtet sind. In entsprechender Weise können auch die Schmalseiten und/oder der untere Längsrand der Seitenblenden 3 sowie der Frontblende 4 bzw. Rückblende 5 rechtwinklig nach innen abgekantet sein. Die abgekanteten Ränder weisen für Befestigungs- bzw. Montagezwecke Durchbrüche auf, die beispielsweise in Form von Lochreihen mit bestimmtem Rasterabstand angeordnet sein können, so dass sich einfache Montagemöglichkeiten ergeben. In den Eckbereichen des Sockels 1 sind Eckstücke 2 angeordnet, über die die Seitenblenden 3 mit der Frontblende 4 und Rückblende 5 verbunden sind, wobei Frontseiten bzw. Rückseiten der Eckstücke 2 parallel abgesetzt oder bündig in die Ebene der Frontblende 4 bzw. Rückblende 5 und rechtwinklig zu der Frontseite bzw. Rückseite abgewinkelte Seitenteile der Eckstücke 2 parallel abgesetzt oder bündig in die Ebene der Seitenblenden 3 übergehen. Wie näher aus den Fig. 2 und 3 ersichtlich, weisen die Eckstücke 2, parallel beabstandet von ihrer Frontseite bzw. Rückseite angeordnete Montageflächen mit Montageöffnungen 2.1, 2.2 in Form viertikal verlaufender Lochreihen auf. Außerdem sind die Eckstücke 2 mit Verbindungslaschen zum Verbinden mit der Frontblende 4 bzw. Rückblende 5 versehen. Wie Fig. 8 zeigt, können die Seitenblenden 3 aus einer oberen und einer unteren Teilblende 3', 3" zusammengesetzt sein.

Wie Fig. 1 weiterhin zeigt, umfasst die Grundverteilereinheit 10 vorliegend zwei übereinander angeordnete, vertikal beabstandete, horizontal sich zwischen den Seitenblenden 3 erstreckende Leitungsrohre 11 auf, die mittels seitlicher Befestigungseinheiten 18 z. B. an zwei Eckstücken 2 oder an den Seitenblenden 3 angebracht sind. Die Fig. 2 und 3 zeigen z. B. die Befestigung der Befestigungseinheiten 18 an einem jeweiligen Eckstück 2 an den zum Sockelinneren liegenden Montageöffnungen 2.1. Die jeweilige Befestigungseinheit 18, die z. B. eine quaderförmige Außengestalt besitzt, ist aus zwei miteinander verspannbaren Halteelementen 18.1, 18.1' zusammengesetzt, die jeweilige, komplementär zueinander ausgebildete einstückige Teil-Halteaufnahmen zum Bilden einer Halteaufnahme 18.2 besitzen, die auf den Außenumfang der Leitungsrohre 11 abgestimmt sind und diese aufnehmen. Die Anzahl der Halteaufnahmen 18.2' entspricht der Anzahl der Leitungsrohre 11 der Grundverteilereinheit 10, so dass eine eindeutige, einfache Montage gewährleistet ist. Die Befestigungseinheit 18 weist vorzugsweise mit Gewinde versehene Befestigungsbohrungen 18.3 auf, die an den Abstand und die Position geeigneter Montageöffnungen 2.1 des Eckstückes 2 angepasst sind, um sie mittels Schrauben an dem Eckstück 2 zu befestigen.

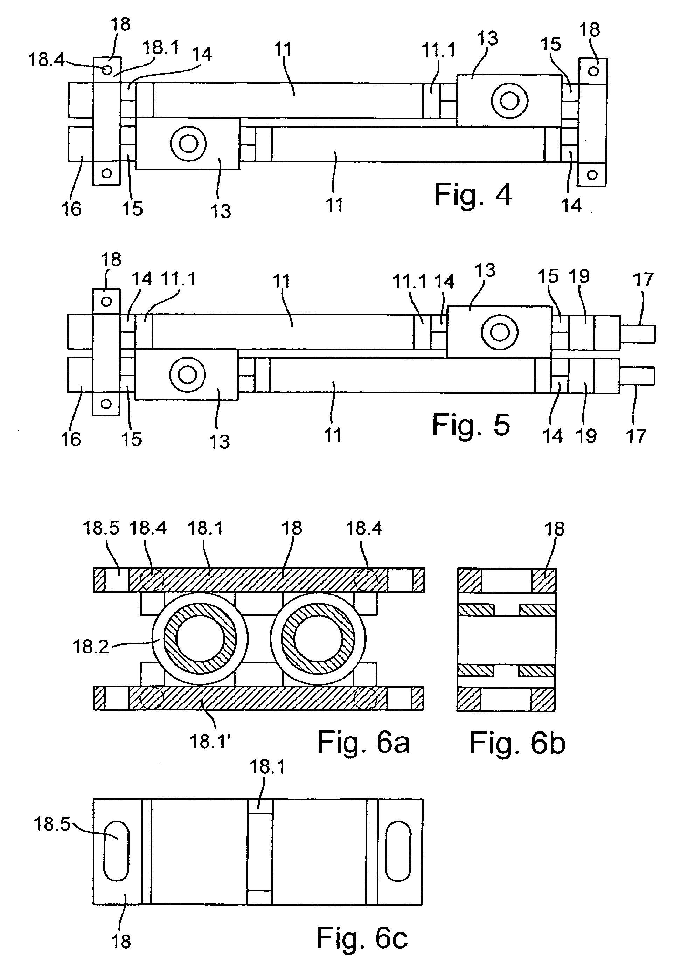

Wie die Fig. 4 bis 8 erkennen lassen, können die Befestigungseinheiten auch mit weiteren Befestigungsöffnungen 18.4 bzw. 18.5 versehen sein, die auf Löcher in den abgekanteten Rändern der Seitenblenden 3 oder deren Teilblenden 3', 3" abgestimmt sind, um sie daran allein oder zusätzlich anzubringen. Dies ergibt erweiterte Montagemöglichkeiten.

Wie Fig. 1 weiterhin zeigt, sind in den Seitenblenden 3 im Bereich der Öffnungen der Leitungsrohre 11 der Grundverteilereinheit 10 Durchbrüche 3.1 angeordnet, über die die Leitungsrohre 11 mit weiteren Leitungen, insbesondere Leitungsrohren 11 eines benachbarten Schranks oder Racks verbindbar sind. In aneinander gereihter Anordnung zweier oder mehrerer Schränke können die Seitenblenden 3 der einander benachbarten Seiten des Sockels 1 auch weggelassen werden. In den Fig. 4 und 5 sind zwei unterschiedlich ausgestaltete Grundverteilereinheiten 10 gezeigt, wobei in Fig. 4 eine Grundverteilereinheit für einen Schrank oder ein Rack dargestellt ist, während in Fig. 5 eine für eine Anreihung zweier bzw. mehrerer Schränke ausgebildete Grundverteilereinheit 10 dargestellt ist.

Die in Fig. 4 dargestellte Grundverteilereinheit 10 weist zwei Leitungsrohre 11 mit an deren Endabschnitten angebrachten Anschlussstücken 11.1 auf. Auf einer Seite des jeweiligen Leitungsrohres 11 ist über das Anschlussstück 11.1 ein Abzweigstück 13 angeschlossen, wobei das Anschlussstück 11.1 ein Außengewinde und das Abzweigstück 13 ein darauf abgestimmtes Innengewinde trägt. An das Abzweigstück 13 schließt sich zu der entsprechenden Seite des Sockels 1 hin ein Koppelstück 15 an, das mittels eines Außengewindes an ein Innengewinde auf der zugekehrten Seite des Abzweigstückes 13 angeschlossen ist. Über ein weiteres Außengewinde des Koppelstückes 15 kann eine Anschlussleitung angeschlossen werden. Auf der von dem Abzweigstück 13 abgewandten Seite des Leitungsrohres 11 ist an dessen Anschlussstück 11.1 ein weiteres Koppelstück 14 angeschlossen, an das ein Kupplungsstück 16 zum Verbinden mit einer Anschlussleitung anschließt. Bei dem anderen Leitungsrohr 11 sind das genannte Abzweigstück 13, das Koppelstück 15, das weitere Koppelstück 14 sowie das Kupplungsstück 16 seitenvertauscht angeschlossen, wie Fig. 4 zeigt.

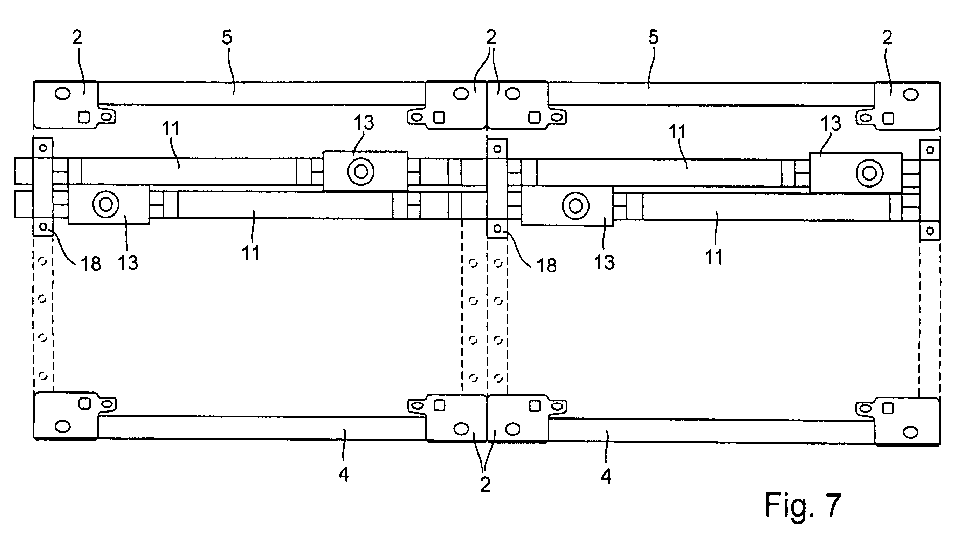

Bei der in Fig. 5 gezeigten, für eine Anreihung ausgebildeten Grundverteilereinheit 10 sind gegenüber der in Fig. 4 gezeigten Grundverteilereinheit 10 auf einer Seite, vorliegend auf der rechten Seite, an die beiden Koppelstücke 14, 15 jeweils über ein Zwischenstück 19 z. B. in Form eines Doppelnippels mit Innengewinde, jeweils eine Schnellverschlusskupplung 17 angeschlossen, die durch einfaches Ankuppeln an den Kupplungsstücken 16 einer benachbarten Grundverteilereinheit 10 in einem benachbarten Schrank oder Rack beim Anreihen ohne Weiteres dicht anschließbar sind, um die Strömungsverbindung herzustellen, wie Fig. 7 zeigt. Dabei sind die Kupplungsstücke 16 als Schnellverschlusskupplungen mit Muffen zur Aufnahme einer Grundverteilereinheit 10 für die Anreihung ausgebildet und können gegen Verschlussschrauben bei Einzeleinsatz der Grundverteilereinheit 10 einfach ausgetauscht werden.

Wie die beschriebenen Ausführungsbeispiele nach Fig. 4 und 5 zeigen, können die Grundverteilereinheiten 10 für einen einzelnen Schrank bzw. ein einzelnes Rack oder für eine Anreihung leicht durch einfachen Anschluss der Zwischenstücke 19 und Schnellverschlusskupplungen 17 bzw. Abnahme derselben ineinander umgewandelt werden. Die Leitungsrohre 11 bestehen z. B. aus einfachen Gummidruckschläuchen mit jeweils zwei an ihren Enden angebrachten Gewinden, wobei die Länge der Gummidruckschläuche entsprechend der Breite des Schranks oder Racks variiert.

Wie die Fig. 1, 2 und 8 erkennen lassen, sind über die T-förmigen Abzweigstücke 13 über deren Abzweiganschluss, der ebenfalls mit einem Innengewinde versehen ist, die durch die Sockelabdeckung 6 geführten Anschlussleitungen 12 angeschlossen. Die Anschlussleitungen 12 sind mit ihren anderen Enden z. B. an im Rahmenprofil des Schranks oder Racks verlaufende Verbindungskanäle 8 oder aber direkt an dem eingangsseitigen bzw. ausgangsseitigen Leitungsende einer Kühlschlange angeschlossen. Das Kühlmedium kann auf diese Weise einfach z. B. einer Kühlplatte der eingangs genannten Art zugeführt und von dieser nach Aufnahme der Verlustwärme abgeführt werden. Die Grundverteilereinheit 10 bietet eine einheitliche, in allen Schränken bzw. Racks ungehindert vorinstallierbare Vorrichtung, über die einfache Anschlussmöglichkeiten einerseits z. B. an eine Rückkühlanlage und andererseits an die im jeweiligen Schaltschrank vorhandene Kühleinrichtung bestehen.

## Patentansprüche

1. Schaltschrank oder Rack mit einem unter einem Nutzraum angeordneten Sockel (1) und einer eine Kühlmittel-Leitung aufweisenden Verteilereinrichtung für ein eine Kühleinrichtung durchströmendes Kühlmedium,
**dadurch gekennzeichnet,**
**dass** die Verteilereinrichtung als Grundverteilereinheit (10) ausgebildet ist, die im Bereich des Sockels (1) installiert ist und sich mit mindestens einem Leitungsrohr (11) zwischen zwei parallel beabstandeten vertikalen Begrenzungsebenen des Sockels (1) erstreckt, und
**dass** das Leitungsrohr (11) mit mindestens einem Abzweigstück (13) zum Anschluss der Kühleinrichtung versehen ist.

2. Schaltschrank oder Rack nach Anspruch 1,
**dadurch gekennzeichnet,**
**dass** sich das mindestens eine Leitungsrohr (11) zwischen zwei Seitenblenden (3) des Sockels (1) erstreckt und über mindestens eine Seitenblende (3) und/oder mindestens ein Eckstück (2) mit dem Sockel (1) verbunden ist.

3. Schaltschrank oder Rack nach Anspruch 1 oder 2,
**dadurch gekennzeichnet,**
**dass** die Grundverteilereinheit (10) zum Verbinden des mindestens einen Leitungsrohrs (11) an dem Sockel (1) mindestens eine Befestigungseinheit (18) aufweist.

4. Schaltschrank oder Rack nach einem der vorhergehenden Ansprüche,
**dadurch gekennzeichnet,**
**dass** zumindest ein Endabschnitt und/oder das Abzweigstück (13) des jeweiligen Leitungsrohres (11) mit einem freigebbaren Schließelement zum fluiddichten Verschließen des Leitungsrohres (11) versehen ist/sind.

5. Schaltschrank oder Rack nach einem der vorhergehenden Ansprüche,
**dadurch gekennzeichnet,**
**dass** die Grundverteilereinheit (10) durch Anbringung einer mit einem Steckteil versehenen Schnellverschlusskupplung (17) an einem Ende des jeweiligen Leitungsrohres (11) als Anreihverteilereinheit ausgebildet ist.

6. Schaltschrank oder Rack nach einem der vorhergehenden Ansprüche,
**dadurch gekennzeichnet,**
**dass** der Sockel (11) auf seiner Oberseite mittels einer Sockelabdeckung (6) abgedeckt ist, die zum Durchführen einer Verbindungsleitung zwischen dem jeweiligen Abzweigstück (13) und der Kühleinrichtung mit mindestens einem dichtenden Durchführelement (7) versehen ist.

7. Schaltschrank oder Rack nach einem der Ansprüche 3 bis 6,
**dadurch gekennzeichnet,**
**dass** die Befestigungseinheit (18) zwei gegeneinander verspannbare Klemmenschalen (18.1, 18.1') aufweist, die jeweils einstückig mit jeweiligen Halteaufnahmen (18.2) für alle Rohrleitungen (11) ausgebildet sind.

8. Schaltschrank oder Rack nach einem der vorhergehenden Ansprüche,
**dadurch gekennzeichnet,**
**dass** die Seitenblenden (3) mit Durchbrüchen (3.1) für die Leitungsrohre (11) versehen sind.

9. Schaltschrank oder Rack nach einem der vorhergehenden Ansprüche,
**dadurch gekennzeichnet,**
**dass** die Seitenblenden (3) aus einer unteren und einer oberen Teilblende (3', 3") zusammengesetzt sind.

10. Schaltschrank oder Rack nach einem der Ansprüche 2 bis 9,
**dadurch gekennzeichnet,**
**dass** die Seitenblenden (3) zumindest an ihrem oberen Längsrand bezüglich des Sockelraumes rechtwinklig nach innen abgekantet sind und in dem abgekanteten Abschnitt Befestigungslöcher aufweisen.

## Claims

1. Switching cabinet or rack with a base (1) and distributing device that has a coolant pipe for a coolant that flows through a cooling device arranged below a usable space, **characterized in that** the distributing advice is designed as the basic distribution unit (10), which is installed in the base area (1) and extends with at least one pipe (11) between two parallel, spaced-apart, vertical limiting planes of the base (1) and **in that** the pipe (11) has at least one branch piece (13) for connecting the cooling device.

2. Switching cabinet or rack as per Claim 1 **characterized in that** at least one pipe (11) extends between two side panels (3) of the base (1) and is connected to the base(1) via at least one side panel (3) and/or at least one corner piece (2).

3. Switching cabinet or rack as per Claim 1 or 2, **characterized in that** the basic distribution unit (10) has at least one mounting device (18) for connecting at least one pipe (11) to the base (1).

4. Switching cabinet or rack as per one of the aforementioned claims, **characterized in that** at least one end section and/or branch piece (13) of the respective pipe (11) is/are provided with a closing element that can be released for the fluid-tight sealing of the pipe (11).

5. Switching cabinet or rack as per one of the aforementioned claims, **characterized in that** the basic distribution unit (10) is designed as a modular distribution unit through the fitting of a quick-connecting coupling (17) with a plug-in part at one end of the respective pipe (11).

6. Switching cabinet or rack as per one of the aforementioned claims, **characterized in that** the base (11) is covered on its upper side by a base cover (6), which is provided with at least one sealing duct (7) to create a connecting pipe between the respective branch piece(13) and the cooling device.

7. Switching cabinet or rack as per one of the claims 3 to 6, **characterized in that** the mounting device (18) has two opposed clamping shells (18.1, 18.1') that can be tightened down , which are designed as a one-piece with respective mountings (18.2) for all pipes (11).

8. Switching cabinet or rack as per one of the aforementioned claims **characterized in that** the side panels (3) are drilled with thru-holes (3.1) for the pipes (11).

9. Switching cabinet or rack as per one of the aforementioned claims, **characterized in that** the side panels (3) are composed of lower and upper sections of the panel (3', 3").

10. Switching cabinet as per one of the claims 2 to 9, **characterized in that** the side panels (3) ,at least on their upper lengthways edge, are folded inwards perpendicular to the base area and have fixing holes in the folded section.

## Revendications

1. Armoire de commutation ou baie de stockage comprenant une embase (1) placée au-dessous d'un espace utile, et un dispositif répartiteur muni d'un conduit à agent de refroidissement et destiné à un fluide de refroidissement parcourant un système refroidisseur,
**caractérisée par le fait**
**que** le dispositif répartiteur est réalisé sous la forme d'une unité de répartition (10) au sol, qui est installée dans la région de l'embase (1) et s'étend, par au moins une tubulure de canalisation (11), entre deux plans verticaux de délimitation de ladite embase (1), parallèlement espacés, et
**que** ladite tubulure de canalisation (11) est munie d'au moins une pièce de bifurcation (13), en vue du raccordement du système refroidisseur.

2. Armoire de commutation ou baie de stockage selon la revendication 1,
**caractérisée par le fait**
**que** la tubulure de canalisation (11), prévue au minimum, s'étend entre deux écrans latéraux (3) de l'embase (1) et est reliée à ladite embase (1) par l'intermédiaire d'au moins un écran latéral (3), et/ou d'au moins une pièce d'angle (2).

3. Armoire de commutation ou baie de stockage selon la revendication 1 ou 2,
**caractérisée par le fait**
**que** l'unité de répartition (10) au sol présente au moins une unité de fixation (18) conçue pour relier, à l'embase (1), la tubulure de canalisation (11) prévue au minimum.

4. Armoire de commutation ou baie de stockage selon l'une des revendications précédentes,
**caractérisée par le fait**
**qu'**au moins une région extrême, et/ou la pièce de bifurcation (13) de la tubulure de canalisation (11) respective, est/sont dotée(s) d'un élément obturateur libérable en vue de l'obturation de ladite tubulure de canalisation (11), avec étanchéité aux fluides.

5. Armoire de commutation ou baie de stockage selon l'une des revendications précédentes,
**caractérisée par le fait**
**que** l'unité de répartition (10) au sol est réalisée sous la forme d'une unité répartitrice aboutable par mise en place, à une extrémité de la tubulure de canalisation (11) respective, d'un accouplement (17) de fermeture rapide qui est pourvu d'une partie emboîtable.

6. Armoire de commutation ou baie de stockage selon l'une des revendications précédentes,
**caractérisée par le fait**
**que** l'embase (1) est recouverte, sur sa face supérieure, au moyen d'une coiffe (6) munie d'au moins un élément de traversée (7) à effet d'étanchement, en vue du passage d'une conduite de jonction entre le système refroidisseur et la pièce de bifurcation (13) respective.

7. Armoire de commutation ou baie de stockage selon l'une des revendications 3 à 6,
**caractérisée par le fait**
**que** l'unité de fixation (18) comprend deux coques de serrage (18.1, 18.1') qui peuvent être bloquées l'une contre l'autre et sont respectivement réalisées, d'un seul tenant, avec des logements respectifs de retenue (18.2) dédiés à toutes les canalisations tubulaires (11).

8. Armoire de commutation ou baie de stockage selon l'une des revendications précédentes,
**caractérisée par le fait**
**que** les écrans latéraux (3) sont pourvus de perforations (3.1) dévolues aux tubulures de canalisation (11).

9. Armoire de commutation ou baie de stockage selon l'une des revendications précédentes,
**caractérisée par le fait**
**que** les écrans latéraux (3) sont composés d'écrans partiels (3', 3") inférieur et supérieur.

10. Armoire de commutation ou baie de stockage selon l'une des revendications 2 à 9,
**caractérisée par le fait**
**que** les écrans latéraux (3) sont coudés à angle droit vers l'intérieur vis-à-vis de l'espace circonscrit par l'embase, au moins sur leur bord longitudinal supérieur, et comportent des trous de fixation dans la région coudée.
